# EUROPEAN PATENT APPLICATION

(11) **EP 2 045 034 A1**
(43) Date of publication of application: **08.04.2009**
(21) Application number: 08165947.6
(22) Date of filing: 06.10.2008
(51) Int. Cl.: B23K 26/06, H01L 21/60

(54) **Flip-chip mounting apparatus**

(30) Priority: 03.10.2007 JP 2007260070
(71) Applicant: Shinko Electric Industries Co., Ltd., Nagano-shi, Nagano 381-2287 (JP)
(72) Inventor: Murayama, Kei, Nagano 381-2287 (JP)
(74) Representative: Zimmermann & Partner

(57) **Abstract**

A flip-chip mounting apparatus 10 includes a variable-shape mirror 16 for receiving a laser beam emitted from a laser beam oscillating source 12, a sensor 18 for sensing a reflected laser beam from the variable-shape mirror 16, and a controlling portion 20 for controlling the variable-shape mirror 16 by comparing a sensed signal input from the sensor 18 with previously input threshold values such that an intensity distribution of the reflected laser beam corresponds to a distribution of bumps 37 on a semiconductor chip 36, whereby when the reflected laser beam from the variable-shape mirror 16 is irradiated onto the semiconductor chip 36 through a beam expander 34 and a pushing body 40, a beam shape of the reflected laser beam matches with an outer shape of the semiconductor chip 36 and also joined portions are heated in a concentrated manner.

## Description

### BACKGROUND OF THE INVENTION

The present invention relates to a flip-chip mounting apparatus for flip-chip connecting a semiconductor chip to a substrate by laser beam. Further, the present disclosure also relates to a method for flip-chip connecting a semiconductor chip to a substrate.

When mounting a semiconductor chip, on which bumps for external connection are formed in a required pattern, on a substrate, the flip-chip (FC) connection is carried out by the flip-chip mounting apparatus in a following manner.
That is, positions of the bumps of the semiconductor chip are adjusted and aligned with pads which are formed on the substrate in a required pattern and the semiconductor chip is loaded on the substrate. Then, a ceramic heater is put on a back surface of the semiconductor chip and the semiconductor chip is heated while applying pressure by the ceramic heater. Thereby, the FC connection is obtained by the melted solders.
However, there is a great difference in coefficient of thermal expansion between a resin of the substrate material and a silicon of the semiconductor chip. Therefore, because of shrinkage of the substrate after the connection is completed, such a problem is caused that either displacements occur between the bumps and the pads or cracks open in the joined portions.
In particular, these days the bumps and the pads are formed in patterns at a narrow pitch due to a high-density wiring demands. As a result, the problem of above displacements or cracks arises conspicuously.

When the ceramic heater is used, temperature rises slowly and an overshoot is large. Therefore, temperature control is difficult, which also constitutes one factor of the problem.
For this reason, in order to solve this problem, recently, the method of applying a short-time and intensive heating by using a laser beam as a heating source is employed (see Japanese Patent Unexamined Publication JP-A-2001-148403).
Particularly, the heating equipment in the JP-A-2001-148403 has a laser oscillator for irradiating a laser beam from the back surface side of the semiconductor chip, a lens as a beam expander of the laser beam emitted from the laser oscillator, a phase difference plate for focusing the laser beam passed through the lens on bumps and their neighborhoods of the semiconductor chip arranged on a stage, and a pressurizing tool formed of a glass to apply a pressure to the semiconductor chip from the back surface side, wherein the laser beam is irradiated only to the bumps and their neighborhoods of the semiconductor chip in the heating operation.

Like the JP-A-2001-148403, when using the laser beam, the heating can be applied in a short time. Therefore, a temperature rise on the substrate side made of a resin can be suppressed, and correspondingly a thermal shrinkage can be reduced and thus the occurrence of displacements or cracks can be reduced to the utmost.
However, normally a profile of the semiconductor chip is rectangular. On contrary, the expanded leaser beam has a circular shape even after an intensity distribution is adjusted by a phase difference plate. Therefore, when a rectangular semiconductor chip is irradiated with a circular leaser beam, the leaser beam which irradiates other than the semiconductor chip heats respective portions of the substrate around the semiconductor chip. As a result, the occurrence of displacements or cracks due to a thermal shrinkage cannot be completely eliminated.

### SUMMARY OF THE INVENTION

At least some of the problems in the art are overcome by the flip-chip mounting apparatus according to claim 1 and the method for flip-chip connecting a semiconductor chip to a substrate according to claim 4. Further aspects, details and advantages are evident from the dependent claims, the description and the accompanying drawings.
The present invention has been made to solve the above problems, and it is an object of the present invention to provide a flip-chip mounting apparatus capable of reducing the occurrence of displacements or cracks due to a thermal shrinkage to a minimum.

According to a first aspect of the invention, there is provided a flip-chip mounting apparatus for flip-chip connecting a semiconductor chip to a substrate, including
a laser beam oscillating source,
a beam expander which receives laser beam emitted from the laser beam oscillating source and expands a diameter of the laser beam, and
a pushing body which passes the laser beam whose diameter is expanded by the beam expander and pushes bumps of the semiconductor chip against pads of the substrate;
a variable-shape mirror which receives the laser beam emitted from the laser beam oscillating source and of which reflecting angle of respective fine reflecting surfaces are adjustable;
a sensor which senses laser beam reflected from the variable-shape mirror and
a controlling portion which controls the variable-shape mirror by comparing a sensed signal input from the sensor with threshold values input in advance such that an intensity distribution of the reflected laser beam corresponds to a distribution of the bumps on the semiconductor chip.

According to a second aspect of the invention, it is preferable that the pushing body is capable of holding the semiconductor chip.
According to a third aspect of the invention, it is preferable that the flip-chip mounting apparatus as set forth in the second aspect of the invention, further including:
a head portion having at least the beam expander and the pushing body;
a vertically moving mechanism which moves the head portion vertically;
a turning portion which turns the head portion around an axis line;
an XY table which is arranged under the head portion and on which the substrate is loaded;
a driving portion which moves the XY table in a horizontal plane;
a camera unit which senses bump positions of the semiconductor chip held by the pushing body and pad positions of the substrate loaded on the XY table and
a position matching controlling portion which adjusts the bump positions of the semiconductor chip so as to match the pad positions of the substrate in accordance with a signal from the camera unit.

According to the present invention, the variable-shape mirror is controlled such that the intensity distribution of the reflected laser beam corresponds to the distribution of the bumps on the semiconductor chip. As a result, the beam shape of the reflected laser beam matches with the outer shape of the semiconductor chip and also the joining portions are heated concentratedly. Therefore, such advantages can be achieved that a temperature of the substrate made of resin seldom rises and also the occurrence of displacements between the bumps and the pads or cracks in the joined portions due to a thermal shrinkage of the resin can be reduced to a minimum.
According to one or more aspects of the present disclosure, there is provided a method for flip-chip connecting a semiconductor chip to a substrate. The method comprises: (a) expanding a diameter of a laser beam; (b) passing the expanded laser beam by a pushing body and pushing bumps of the semiconductor chip against pads of the substrate; (c) reflecting the laser beam on a variable-shape mirror; (d) sensing the laser beam reflected from the variable-shape mirror; and (e) controlling the intensity distribution of the reflected laser beam so that the intensity distribution of the reflected laser beam corresponds to a distribution of the bumps on the semiconductor chip.
According to yet another aspect of the present disclosure, there is provided a flip-chip mounting apparatus which includes a variable-shape mirror for receiving a laser beam emitted from a laser beam oscillating source, a sensor for sensing a reflected laser beam from the variable-shape mirror, and a controlling portion for controlling the variable-shape mirror by comparing a sensed signal input from the sensor with previously input threshold values such that an intensity distribution of the reflected laser beam corresponds to a distribution of bumps on a semiconductor chip, whereby when the reflected laser beam from the variable-shape mirror is irradiated onto the semiconductor chip through a beam expander and a pushing body, a beam shape of the reflected laser beam matches with an outer shape of the semiconductor chip and also joined portions are heated in a concentrated manner.

### BRIEF DESCRIPTION OF THE DRAWINGS

Embodiments of the present invention will be described with respect to the accompanying drawings in more detail in the following.
FIG. 1 is a schematic view of maj or portions of a flip-chip mounting apparatus;
FIG.2 is a schematic view of an overall flip-chip mounting apparatus;
FIG.3 is an explanatory view of the principle of a variable-shape mirror;
FIG.4 is a schematic view showing an intensity distribution of a laser beam emitted from a laser beam oscillating source;
FIG.5 is a schematic view showing an intensity distribution of a reflected laser beam adjusted by a controlling portion;
FIG.6 is a schematic view showing an intensity distribution of the reflected laser beam whose beam diameter is expanded by a beam expander;
FIG.7A is a schematic view showing an example of arrangement of bumps;
FIG. 7B is a schematic view showing an intensity distribution of a reflected laser beam adjusted to suit this arrangement example of bumps;
FIG.8A is a schematic view showing another example of arrangement of bumps and
FIG.8B is a schematic view showing an intensity distribution of a reflected laser beam adjusted to suit this arrangement example of bumps.

### DETAILED DESCRIPTION OF THE PREFERRED EMBODIMENTS

Preferred embodiments of the present disclosure will be explained in detail with reference to the accompanying drawings hereinafter.

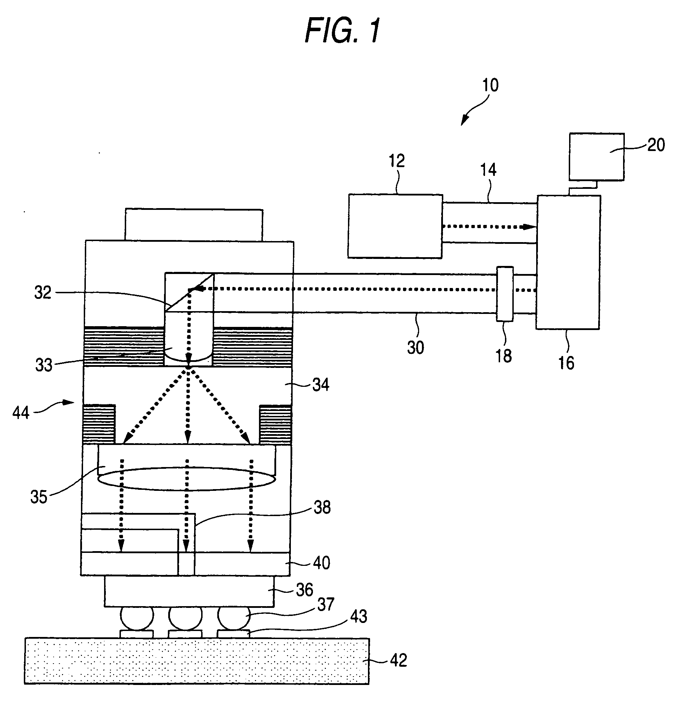

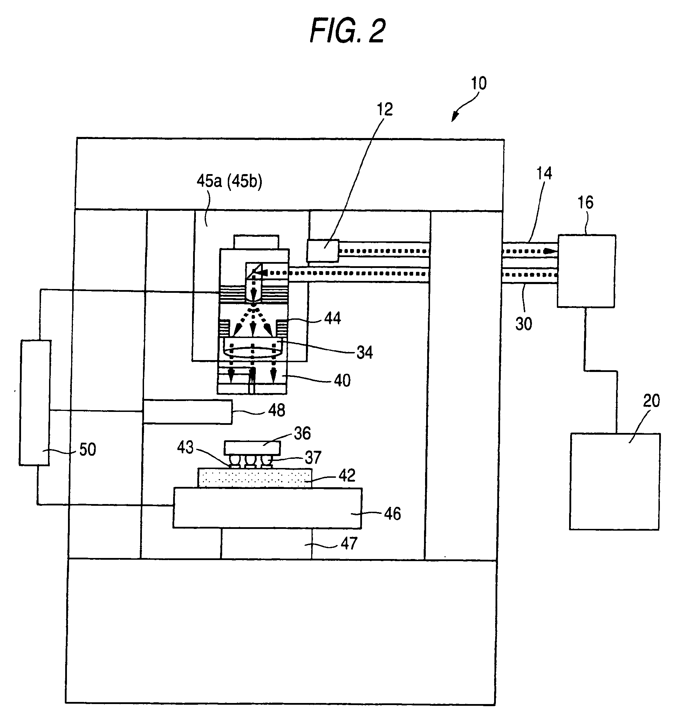

FIG.1 is a schematic view of maj or portions of a flip-chip mounting apparatus 10, and FIG.2 is a schematic view of an overall flip-chip mounting apparatus.
A reference numeral 12 denotes a laser beam oscillating source. The laser is not particularly limited; either of a gas laser, a solid laser, a semiconductor laser, and the like may be employed. Any laser may be employed if such laser can heat bumps of a semiconductor chip and pads of a substrate up to temperature at which respective joined portions can be flip-chip connected.

A laser beam emitted from the laser beam oscillating source 12 is incident on a variable-shape mirror 16 through an optical fiber cable 14.
The laser beam is reflected by the variable-shape mirror 16, and this reflected laser beam is sensed by a sensor 18. The sensor 18 senses intensity distribution of the reflected laser beam as an output current, and inputs this sensed signal into a controlling portion 20.

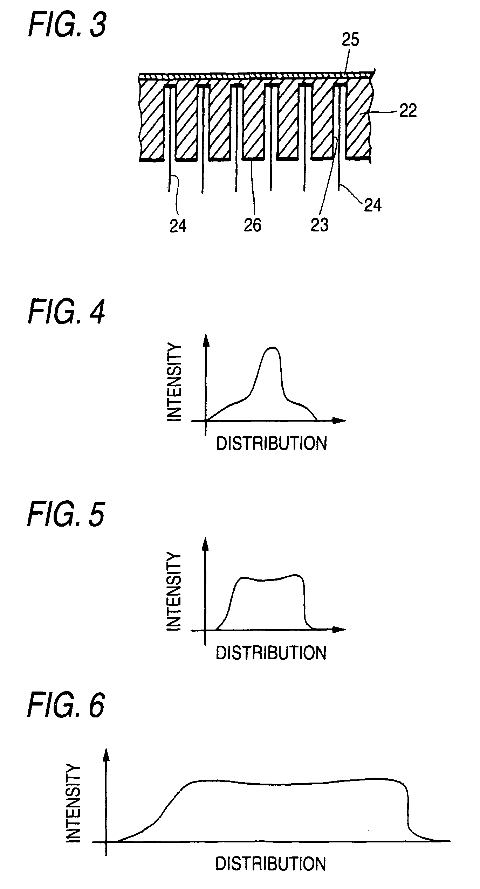

The configuration of the variable-shape mirror 16 is a known mechanism. For example, as shown in FIG. 3, there is the variable-shape mirror 16 in which a plurality of holes 23 are provided in a piezoelectric element 22, a lead 24 is arranged in the holes 23 respectively and one ends of the lead 24 are fixed to electrodes on bottom portions of the holes 23 respectively, a reflecting surface 25 is provided on a surface of the piezoelectric element 22, and a common electrode 26 is provided on the other surface side of the piezoelectric element 22.
In the variable-shape mirror 16, a certain voltage is applied between both electrodes of the piezoelectric element 22 respectively, so that different deformations can be produced in portions of the piezoelectric element 22 corresponding to respective leads 24. The controlling portion 20 can adjust a beam (sectional) shape of the reflected leaser beam and an intensity distribution of the laser beam in compliance with a required program, by causing areas of the reflecting surface 25 corresponding to the portions of the piezoelectric element 22 to produce local deformations thereon. In other words, a reflection angle of the reflecting surface 25 can be adjusted every minute area respectively.

The reflected laser beam from the variable-shape mirror 16 is incident on a beam expander 34 having lenses 33, 35 through an optical fiber cable 30 and a mirror 32. Then, the laser beam is expanded to the beam, which has the same sectional shape as an outer shape of a semiconductor chip 36, by the beam expander 34. In this case, a sectional shape of the beam is adjusted in advance by the variable-shape mirror 16 such that the rectangular beam is similar to the outer shape of the rectangular semiconductor chip 36, as described above.

Also, bumps 37 are aligned in a concentric fashion on the semiconductor chip 36, for example. In this case, an intensity distribution of the reflected laser beam is adjusted by adjusting the reflection angle in respective minute areas of the reflecting surface 25 of the variable-shape mirror 16 such that the reflected laser beam is concentrated in the concentric bump area.

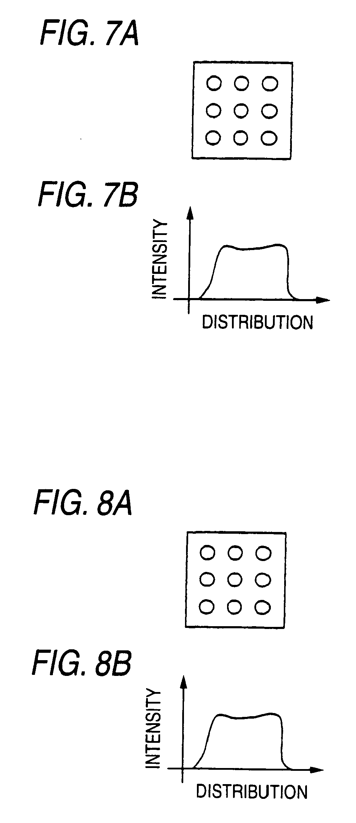

FIG.4 is a schematic view showing the intensity distribution of the laser beam emitted from a laser beam oscillating source 12. FIG.5 is a schematic view showing the intensity distribution of the reflected laser beam adjusted by the controlling portion 20. FIG.6 is a schematic view showing an intensity distribution of the reflected laser beam whose beam diameter is expanded by the beam expander 34. FIG. 7 and FIG. 8 are schematic views showing an example of arrangement of the bumps (FIG.7A, FIG.8A) respectively, and intensity distribution of the reflected laser beam adjusted to suit this arrangement example of the bumps (FIG.7B, FIG.8B) respectively.

A sucking head portion (pushing body) 40 having a sucking hole 38 is arranged under the beam expander 34. The sucking head portion (pushing body) 40 is formed of a transparent glass, and allows the reflected laser beam to pass therethrough.
The sucking head portion 40 can hold the semiconductor chip 36 when an air is sucked through the sucking hole 38 by a sucking device (not shown).
A reference numeral 42 denotes a substrate, and a reference numeral 43 denotes a pad that is formed in plural on the substrate 42 to have the same pattern as the bumps 37.

a head portion 44 has the mirror 32, the beam expander 34, the sucking head portion 40, and other components.
The head portion 44 is mounted on a flip-chip mounting apparatus 10 (FIG.2), and can be moved vertically by a vertically moving mechanism 45a. The head portion 44 can be turned within a certain angle range around an axis line by a turning portion 45b.
An XY table 46 is arranged under the head portion 44, and can be moved in an X-axis direction and a Y-axis direction by driving portion 47.
The substrate 42 is loaded on the XY table 46.
A reference numeral 48 denotes a camera unit that monitors a position in the vertical direction to align the bump 37 with the pads 43. The camera unit 48 is arranged between the head portion 44 and the XY table 46 to move back and forth.

Then, an operation of the flip-chip mounting apparatus 10 which flip-chip connecting the semiconductor chip 36 to the substrate 42 will be explained hereunder.
The head portion 44 is lifted up over the XY table 46. The substrate 42 is arranged on the XY table 46.
The sucking head portion 40 of the head portion 44 is caused to hold the semiconductor chip 36 on the back surface side.

The camera unit 48 is advanced into a space between the head portion 44 and the XY table 46, and senses respective positions of the bumps 37 of the overlying semiconductor chip 36 and the pads 43 of the underlying substrate 42. The position matching controlling portion 50 moves the XY table 46 in the horizontal direction, and turns the head portion 44 around an axis line by an adequate angle to align the bumps 37 with the pads 43.
Then, the camera unit 48 is retreated from the space between the head portion 44 and the XY table 46.

The head portion 44 is moved downward by the vertically moving mechanism 45a to bring the bumps 37 into contact with the pads 43.
In this state, the laser beam is emitted from the laser beam oscillating source 12, and is incident on the variable-shape mirror 16 through the optical fiber cable 14.
The laser beam reflected by the variable-shape mirror 16 is sensed by the sensor 18, and then a sensed signal is input into the controlling portion 20. The sensor 18 senses the laser beam as the intensity distribution in the cross section of the reflected laser beam.

Set data of the current value and threshold values, which realize the intensity distribution of the reflected laser beam corresponding to the arrangement pattern of the bumps 37 as shown in FIG.5, are input into the controlling portion 20 in advance.
The controlling portion 20 executes the feedback control by comparing the sensed signal being input from the sensor 18 with the set data of the current value such a way that a predetermined voltage is applied between respective electrodes of the piezoelectric element 22 in the variable-shape mirror 16 in compliance with a predetermined program, and then the local deformations are caused on the reflecting surface 25 corresponding to minutes area portions of the piezoelectric element 22 such that the beam (sectional) shape of the reflected laser beam and the intensity distribution of the laser beam are fell within the above set ranges (threshold ranges). In this stage, the optical path is shut off by a shutter (not shown) so that the semiconductor chip 36 is not irradiated with the reflected laser beam. Otherwise, in this stage of adjustment of the beam shape of the reflected laser beam, the semiconductor chip 36 and the substrate 42 are not set on the head portion 44 and the XY table 46 respectively.

After the adjustment of the beam shape of the reflected laser beam and the intensity distribution is completed, the shutter is opened, and the reflected laser beam is illuminated onto the back surface side of the semiconductor chip 36. Thus, the laser beam is irradiated concentratedly onto the joining portions between the bumps 37 and the pads 43, and the bumps 37 and the pads 43 are joined together respectively. A joining solder is adhered onto at least one side of the bumps 37 and the pads 43. The bumps 37 and the pads 43 are joined together respectively via the melted solder.
After the semiconductor chip 36 is flip-chip connected to the substrate 42, the semiconductor chip 36 held by the sucking head portion 40 is released. Then, the head portion 44 is lifted up, and the joining operation is ended. In this case, it is adaptable to fill an underfill resin into a gap between the semiconductor chip 36 and the substrate 42.

As to the set data of the current value and the threshold value input into the controlling portion 20 in advance, it is more preferable that the set data and the output itself of the laser beam oscillating source 12 should be changed based on the results obtained by executing the flip-chip connection of the semiconductor chip 36 tentatively several times. This is because sometimes the beam shape of the laser beam and the intensity distribution are varied depending upon the mirror 32, the beam expander 34, the sucking head portion 40, and the like.

In one example, the laser beam from the laser beam oscillating source 12 was the mixed laser of the infrared laser of 808 nm and 1064 nm and the green laser of 532 nm. The flip-chip connection could be done by the irradiation at 35 W for 5 second. In this example, temperature of the semiconductor chip 36 was 245 °C. Here, temperature rise of the substrate 42 was seldom appreciated. Further, the occurrence of displacements between the bumps 37 and the pads 43 after joined and the cracks in the joined portions was seldom found.

Further, as another example, the output of the laser beam was decreased to 20 W, the primary heating for giving the irradiation for 1 second (temperature of the semiconductor chip was 15 °C) was carried out. Then, after the output of the laser beam was increased up to 35 W, the secondary heating for giving the irradiation for 4 second (a temperature of the semiconductor chip was 245 °C) was carried out. As a result, the good flip-chip connection could also be done.

While the invention has been described in connection with the exemplary embodiments, it will be obvious to those skilled in the art that various changes and modifications may be made therein without departing from the present invention, and it is aimed, therefore, to cover in the appended claim all such changes and modifications as fall within the true spirit and scope of the present invention.

## Claims

1. A flip-chip mounting apparatus (10) for flip-chip connecting a semiconductor chip (36) to a substrate (42), comprising:
a laser beam oscillating source (12);
a beam expander (34) which receives laser beam emitted from the laser beam oscillating source (12) and expands a diameter of the laser beam;
a pushing body (40) which passes the laser beam whose diameter is expanded by the beam expander (34) and pushes bumps (37) of the semiconductor chip (36) against pads (43) of the substrate (42);
a variable-shape mirror (16) which receives the laser beam emitted from the laser beam oscillating source (12) and of which reflecting angle of respective fine reflecting surfaces are adjustable;
a sensor (18) which senses laser beam reflected from the variable-shape mirror (16); and
a controlling portion (20) which controls the variable-shape mirror (16) by comparing a sensed signal input from the sensor (18) with threshold values input in advance such that an intensity distribution of the reflected laser beam corresponds to a distribution of the bumps (37) on the semiconductor chip (36).

2. The flip-chip mounting apparatus according to claim 1, wherein the pushing body (40) is capable of holding the semiconductor chip (36).

3. The flip-chip mounting apparatus according to claims 1 or 2, further comprising:
a head portion (44) having at least the beam expander and the pushing body;
a vertically moving mechanism (45a) which moves the head portion (44) vertically;
a turning portion (45b) which turns the head portion (44) around an axis line;
an XY table (46) which is arranged under the head portion (44) and on which the substrate (42) is loaded;
a driving portion (47) which moves the XY table (46) in a horizontal plane;
a camera unit (48) which senses bump positions of the semiconductor chip (36) held by the pushing body (40) and pad positions of the substrate (43) loaded on the XY table (46); and
a position matching controlling portion (50) which adjusts the bump positions of the semiconductor chip (36) so as to match the pad positions of the substrate (42) in accordance with a signal from the camera unit(48).

4. A method for flip-chip connecting a semiconductor chip (36) to a substrate (42), the method comprising:
(a) expanding a diameter of a laser beam;
(b) passing the expanded laser beam by a pushing body (40) and pushing bumps (37) of the semiconductor chip (36) against pads (43) of the substrate (42);
(c) reflecting the laser beam on a variable-shape mirror (16);
(d) sensing the laser beam reflected from the variable-shape mirror (16); and
(e) controlling the intensity distribution of the reflected laser beam so that the intensity distribution of the reflected laser beam corresponds to a distribution of the bumps (37) on the semiconductor chip (36).
